(19)

Europäisches
Patentamt
European
Patent Office
Office européen
des brevets

(11)     **EP 1 421 608 B1**

(12)         **EUROPEAN PATENT SPECIFICATION**

(45) Date of publication and mention
of the grant of the patent:
**21.09.2016  Bulletin 2016/38**

(51) Int Cl.:
*H01J 37/317* [(2006.01)]       *H01J 37/08* [(2006.01)]
*H01J 37/244* [(2006.01)]      *H01J 37/20* [(2006.01)]
*H01L 21/265* [(2006.01)]      *H01L 31/115* [(2006.01)]
*B82B 3/00* [(2006.01)]        *G01T 1/00* [(2006.01)]

(21) Application number: **02753938.6**

(22) Date of filing: **27.08.2002**

(86) International application number:
**PCT/AU2002/001150**

(87) International publication number:
**WO 2003/019635 (06.03.2003 Gazette 2003/10)**

(54) **METHOD AND SYSTEM FOR SINGLE ION IMPLANTATION**

VERFAHREN UND SYSTEM ZUR EINZELIONENIMPLANTATION

PROCEDE ET SYSTEME D'IMPLANTATION D'IONS UNIQUES

(84) Designated Contracting States:
**AT BE BG CH CY CZ DE DK EE ES FI FR GB GR
IE IT LI LU MC NL PT SE SK TR**

(30) Priority: **27.08.2001  AU PP728901**

(43) Date of publication of application:
**26.05.2004  Bulletin 2004/22**

(73) Proprietor: **Qucor Pty Ltd
Sydney,
New South Wales 2052 (AU)**

(72) Inventors:
• **JAMIESON, David, Norman
The University of Melbourne,
Melbourne, (AU)**
• **PRAWER, Steven
Sydney, NSW 2052 (AU)**
• **DZURAK, Andrew, Steven
Darlingtont, NSW 2010 (AU)**
• **CLARK, Robert, Graham
Balgowlah Heights, NSW 2093 (AU)**
• **YANG, Changyi
Box Hill, VIC 3128 (AU)**

(74) Representative: **Gill Jennings & Every LLP
The Broadgate Tower
20 Primrose Street
London EC2A 2ES (GB)**

(56) References cited:
**WO-A1-01/80980     WO-A1-02/18266**

WO-A1-02/19036     WO-A1-99/14614
US-A- 4 675 601     US-A- 5 539 203
US-A- 5 539 203     US-A- 5 945 677

• KAMIYA T ET AL: "An automated single ion hit at JAERI heavy ion microbeam to observe individual radiation damage" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 158, no. 1-4, 2 September 1999 (1999-09-02), pages 255-259, XP004253530 ISSN: 0168-583X
• BECKMANN D R ET AL: "Spatially resolved imaging of charge collection efficiency in polycrystalline CVD diamond by the use of ion beam current" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 130, no. 1-4, 1 July 1997 (1997-07-01), pages 518-523, XP004119223 ISSN: 0168-583X
• LLOYD W MASSENGILL: "Cosmic and Terrestrial Single-Event Radiation Effects in Dynamic Random Access Memories" IEEE TRANSACTIONS ON NUCLEAR SCIENCE, IEEE SERVICE CENTER, NEW YORK, NY, US, vol. 43, no. 2, 1 April 1996 (1996-04-01), XP011040319 ISSN: 0018-9499

EP 1 421 608 B1

**(Cont. next page)**

- MILLAR ET AL: "Nanoscale fabrication using single-ion impacts" PROCEEDINGS OF THE SPIE, SPIE, BELLINGHAM, VA; US, vol. 4590, 1 November 2001 (2001-11-01), pages 173-178, XP002958388
- SCHENKEL ET AL.: 'Single ion implantation for solid state quantum computer development' PROCEEDINGS OF SPIE (QUANTUM DOT DEVICES AND COMPUTING), [Online] vol. 4656, March 2002, pages 10 - 15, XP002958386 Retrieved from the Internet: <URL:http://ebit.lbl.gov/publications/SpieQ C-1201.pdf> [retrieved on 2002-10-11]
- SCHENKEL ET AL.: 'Single ion implantation for solid state quantum computer development' PROCEEDINGS OF THE 46TH INTERNATIONAL CONFERENCE ON ELECTRON, ION AND PHOTON BEAM TECHNOLOGY AND NANOFABRICATION (J. VAC. SCI. TECHNOL.), [Online] May 2002, ANAHEIM, XP002958387 Retrieved from the Internet: <URL:http://ebit.lbl.gov/publications/JoVSa TB-2002-schenkel.pdf> [retrieved on 2002-10-11]
- BUEHLER ET AL.: 'Self-aligned fabrication process for silicon quantum computer devices', [Online] no. 5, 28 August 2002, pages 686 - 690, XP020066999 Retrieved from the Internet: <URL:http://arxiv.org/PS_cache/cond-mat/pdf /0208/0208374.pdf> [retrieved on 2002-10-11]
- MILLAR ET AL.: 'Nanoscale fabrication using single-ion impacts' PROCEEDINGS OF SPIE: BIOMEMS AND SMART NANOSTRUCTURES, [Online] vol. 4590, November 2001, pages 173 - 178, XP002958388 Retrieved from the Internet: <URL:http:///www.ph.unimelb.edu.au/src/SRCp apers/nanafab.pdf> [retrieved on 2002-10-11]
- SCHENKEL ET AL.: 'Single ion implantation with low energy highly charged ions' ABSTRACT FOR THE 14TH INTERNATIONAL CONFERENCE ON ION IMPLANTATION TECHNOLOGY, IIT 2002, [Online] 22 September 2002 - 27 September 2002, TAOS, NEW MEXICO, USA, XP002958389 Retrieved from the Internet: <URL:http://www.iit2002.com/Abstracts/Novel TechniquesCONVERTED/SchenkelA3122.pdf> [retrieved on 2002-10-11]
- PATENT ABSTRACTS OF JAPAN & JP 2001 015059 A (UNIV. WASEDA ET AL.) 19 January 2001

## Description

## Technical Field

This invention concerns a method and system for single ion doping and machining by detecting the impact, penetration and stopping of single ions in a substrate. Such detection is essential for the successful implantation of a counted number of $^{31}$P ions into a semiconductor substrate for construction of a Kane quantum computer.

An ion is an atom that has been ionised. We adopt the convention of using the term 'ion' while the atom is in motion, regardless of its ionised state. After the ion has come to rest, we call it an 'atom'.

## Background Art

The Kane computer[1] requires single donor $^{31}$P atoms to be placed in an ordered 1 D or 2D array in crystalline silicon. The atoms must be separated from each other, by 20 nm or less. An alternative architecture is that of Vrijen et al.[2] who propose an array of $^{31}$P atoms in a heterostructure where the atom spacing can be larger than the Kane computer but still of the order of 100 nm. Such precise positioning has proved extremely difficult using conventional lithographic and ion implantation techniques, or using focused deposition. This difficulty is not only with regard to forming arrays of donor atoms with sufficient precision, but also ensuring that only single donor atoms have been introduced into each cell of the array.

Optical lithography has been utilised by semiconductor industries to manufacture integrated circuits with great precision. Optical lithography systems include an exposure tool, mask, resist and processing steps to accomplish pattern transfer from a mask, to a resist, and then to a device. However, the use of resist layers can limit resolution to the wavelength of the radiation used to transfer the pattern in the mask onto the resist. This is presently about 100 nm.

Electron beam lithography, which uses a finely focused electron beam to directly write patterns into resists, can attain better than 20 nm resolution. Further, the "top-down-process", described in a recent patent application[3], uses electron beam lithography to construct arrays of nanoscale channels in resists. The resist is then irradiated with an ion beam so that ions impact at random on the surface allowing a random array of channels to direct one or more atoms through into the substrate to construct nanoscale structures.

However, in all of these lithographic techniques, control of the number of atoms reaching the substrate is not possible.

Lüthi et al.[4] describe a resistless lithography technique which enables the fabrication of metallic wires with linewidths below 100 nm. The technique is based on an ultra-high resolution scanning shadow mask, called a nanostencil. A movable sample is exposed to a collimated atomic or molecular beam through one or more apertures in an atomic force microscope (AFM) cantilever arm. Standard V-shaped $Si_3N_4$ cantilevers with integrated tips having a spring constant below 0.1 Nm$^{-1}$ were used. The aperture diameter ranged from 50 to 250nm depending on the desired mask structure. Scanning the sample with respect to the nanostencil allowed the structure to be laid down on the surface of the sample. After nanostructuring, the structure was inspected with the AFM tip.

This former method allows precise positioning of large numbers of atoms but not implanting and detecting single ions.

Shinada et al.[5] have developed a single ion detection technique using a single ion implantation assembly developed by Koh et al.[6] The single ion implantation assembly consisted of a pair of deflector plates, an objective slit, a precision quadropole-magnet, a target, an electron multiplier tube (EMT) and a chopper control circuit connected to the deflector plates and the EMT. The ion beam is chopped with the pair of deflector plates, over which the potential difference can be switched. Each single ion is extracted one by one from a continuous ion beam by adjusting the ion beam current, the objective slit diameter and the switching time of the potential difference applied to the deflector plates.

The extracted single ion is then focused with the quadropole-magnet lens and impacts on the target. The number of incident ions is controlled by the EMT by detecting secondary electrons emitted upon ion incidence. Signals from the EMT are fed to the chopper control circuit which keeps on sending the beam chopping signals to the deflector until the desired number of single ions are detected.

Shinada et al.[5] emphasised findings by Koh[6] by reporting that the key to controlling the incident ion number is the detection of secondary electrons emitted from a target upon ion incidence.

The secondary electron detection efficiency $P_d$ is defined as follows:

$$P_d = \frac{N_{SE}}{N_{ext}}$$

where $N_{SE}$ is the average number of detected secondary electrons by a single chop and $N_{ext}$ is the average number of extracted ions by a single chop, where $N_{ext}$ is proportional to the ion beam current and the time of beam chopping.

To determine the efficiency in the determination of secondary electrons, a 60 keV $Si^{2+}$ ion beam was chopped with a frequency of 100 kHz. $N_{SE}$ was estimated by dividing the number of secondary electron counts per second by $10^5$. To evaluate $N_{ext}$, a standard fission track detector was used.

The secondary electron detector included a photomultiplier tube with a scintillator and a light guide. A grid electrode was used to guide the secondary electrons to the sensitive part of the scintillator.

The experimental result for $P_d$ was 90%. The error was partially attributed to the limitations of the secondary electron detection system. Furthermore, results showed that the single ion incident position could be successfully controlled with an error of less than 300 nm.

This detection of impacts from the pulse of secondary electrons emitted from the surface due to the ion impacts does not distinguish ion impacts with a mask from ion impacts with an exposed substrate under the mask.

US 5,539,203 (Ohdamari Iwao) describes an arrangement for implanting single, or a counted number of, dopant ions in a substrate 13. An ion (beam) 48 is generated for this purpose and used to irradiate the substrate 13 with a stream of single ions. Ion strike is detected either by back scatter or 'streak detection'. The detected signal is then used to gate the beam off 20. However, in this arrangement the detection of ion strike only indicates that an ion has impacted a surface, for instance the substrate surface, and does not indicate whether the ion has penetrated into the substrate or merely bounced off it. The technique described is therefore not able to reliably indicate whether the ions have been implanted in the substrate. Further, the technique will also provide a false positive detection when an ion strikes the mask above the substrate.

US4675601 describes a method of measuring electric-field funnelling length by irradiating a semiconductor charge collecting junction with electron-hole-pair generating charged particles. Kamiya T et al: "An automated single ion hit at JAERI heavy ion microbeam to observe individual radiation damage", Nuclear Instruments & Methods in Physics Research, Section - B:Beam Interactions with Materials and Atoms, Elsevier, Amsterdam, NL, vol. 158, no. 1-4, 2 September 1999 (1999-09-02), pages 255-259, XP004253530, ISSN: 0168-583X discusses single ion irradiation on preset points of a sample. Beckmann D R et al: "Spatially resolved imaging of charge collection efficiency in polycrystalline CVD diamond by the use of ion beam current", Nuclear Instruments & Methods in Physics Research, Section - B:Beam Interactions with Materials and Atoms, Elsevier, Amsterdam, NL, vol. 130, no 1-4, 1 July 1997 (1997-07-01), pages 518-523, XP004119223, ISSN: 0168-583X describes ion beam induced current imaging using He[+] irradiation.

## Disclosure of Invention

In a first aspect the invention is a method according to claim 1 of the attached claims.

An advantage of the method is that it can be scaled to produce arrays of single atoms using low energy (keV) ion implantation. Also, it is sensitive only to ions that reach the substrate and ignores ions that strike surface masks. It produces a record of each ion impact for verification and further analysis. The ions are detected with close to 100% efficiency. And, it can be used with MeV ions to exploit the latent damage from the passage of a single ion to nanomachine sensitive materials.

The substrate may be a pure semiconductor substrate, such as a high resistivity silicon substrate. However any substrate may be used that is electrically active in the sense that it is ioniseable to form electronhole pairs with a useful lifetime.

Ions may be applied by the use of a focused beam of ions from a field ionisation ion source producing sub-20 nm ion beam probes. Alternatively, a broad-beam implanter can be used. The ion beam current may be adjusted to a level low enough to minimise the probability of multiple ion strikes during the time required to gate off the beam. The required current will depend on the response speed of the ion strike detection and beam gating circuitry. Typically the current will be one hundred atoms per second. Such a beam probe can be used to inject single ions at desired locations either with or without a mask. The required beam current can be tuned by using the single ion detector signal incident on a peripheral region of the substrate that is not itself required in the device to be fabricated.

We will now describe the technique by which ions are detected using the invention. Implanted ions stop in the substrate at a depth determined by the initial ion energy and the stopping power of the substrate. There are two energy loss processes which determine the stopping power. First, nuclear processes where a close collision occurs between a projectile and the substrate nucleus causing a recoil and straggling. Second, electronic processes where ion kinetic energy is transferred to ionisation of the substrate and its attendant production of electron hole pairs. It should be appreciated that only the electronic processes produce a signal detectable by the method.

The ionisation is detected by electrodes which may be placed adjacent to the region to be implanted. Both electrodes may be on the front surface, or one on the front surface and one on the rear surface depending on application. A bias voltage may be applied across them to detect the ion impacts. This leads to the possibility of measuring the polarity of the ion-impact-induced signal as a measure of the proximity of the ion strike to the positive or negative electrode. So, it may be possible to have two nanomachined apertures in the substrate that are implanted with a broad beam, then the aperture which actually receives the ion strike could be identified from the relative strength and polarity of the signal collected from the two electrodes.

A substrate cooling system may be required to maintain the substrate at a low enough temperature (of the order of 77K) to allow sufficient signal to noise ratio to detect keV ions (for MeV ions the substrate may be held at room temperature).

A prototype system has been shown to give very few false signals, such as random noise or from ions that do not penetrate sufficiently far into the substrate. Pulse shape discrimination can eliminate these events.

Acceptable detection signals may be used to generate a gate signal, via a computer, to a feedback circuit which may then gate off the ion beam. Such a control signal may also step a mask to a new position above the substrate for a further implant whereupon the beam is gated on once again.

The system may be enhanced by the use of a thin, ion sensitive resist, that may be processed to reveal the impact sites of single ions. The incident ions pass through the thin resist and enter the substrate leaving a trail of latent damage which can be developed by standard techniques to reveal a pit that can be imaged with an Atomic Force Microscope (AFM). The resulting image of the pits reveals the sites where the implanted ions have entered the substrate.

The system may also be enhanced by the use of a thick resist layer as a nanomachined mask, that blocks the ions from entering the substrate except for the open areas in the mask which expose the desired areas in the substrate where single ions are to be implanted.

For the construction of a two atom device, two apertures may be opened in the mask. This may be achieved using some of the metal electrodes in the finished device. In this case, metal electrodes are fabricated using conventional Electron Beam Lithography (EBL), then a resist layer is deposited. A cross line is drawn with the EBL system across the linear electrodes which upon development then opens a path to the surface leaving the substrate exposed. The mask now consists of the thick metal electrode and the resist layer. Ions can be implanted down the paths beside the electrodes. Some ions will stop in the metal of the electrode, but this will not produce a signal in the ion detection system because ion impacts with metals produces very little charge.

There will be an approximately 50 % chance of producing a device with a single ion in each aperture. This chance will be actually greater than 50% owing to lateral ion straggling. For example, the lateral straggling of 15 keV $^{31}$P ions implanted into silicon for the Kane quantum computer is about 7 nm[7]. There is a significant probability that the situation where both ions entered the substrate through the same aperture will result in the implanted atoms ending up in different locations. They may therefore be separately addressed with the A and J gate electrodes of the quantum computer. There is a significant probability that one or both of the ions will end up in the most desirable location under the A gate electrode itself due to ion straggling. In any case, appropriate tuning of the gate potential can still address the atom, even if it is not precisely located under the electrode. Technology Computer Aided Design (TCAD) calculations show that as long as the two atoms are in different places, they can still be individually addressed.

The system may be used to scale up the array of implanted ions by the use of a moveable mask consisting of a nanomachined aperture in an AFM cantilever which may be accurately positioned above the desired location of the atoms and then irradiated with an ion beam.

The nanomachined apertures may be fabricated with EBL in the resist layer. Alternatively, the nanomachined aperture may be drilled in a standard cantilever and may form part of a Scanning Tunneling Microscope (STM) or an Atomic Force Microscope (AFM). The nanomachined aperture may be fabricated using a Focused Ion Beam (FIB) which itself usually employs a focused beam of Ga ions, diameter less than 20 nm, to image and machine the specimen. By first imaging the cantilever tip with the FIB, the location of the nanomachined aperture can be then accurately drilled at a known location relative to the cantilever tip.

Accurate positioning of the nanomachined aperture above the specimen may be accomplished by using the STM or AFM to first locate and image registration marks on the substrate using the same cantilever containing the nanomachined aperture and to thus effectively align the aperture for an ion to pass through the aperture to implant an ion into the substrate.

Between each implant step, the cantilever could be used to image the ion impact site to image chemical or morphological changes that occur as a result of ion impact to verify that a single ion has been successfully delivered to the substrate.

The moveable mask may be controlled to a precision of less than about 1 nm. The thickness of the moveable mask is sufficient to stop the incident ion beam so that no ions are transmitted except through the aperture.

The system can also be used to produce scaled up arrays directly by using a FIB to implant the ions. The focused probe in the FIB is a sub-20 nm spot. In this case the focused probe is scanned over the substrate, dwelling on the places where the ions are to be implanted. The beam blanking and scan advance is gated on the ion impact signal. The FIB is configured to produce the ion beam required for the particular application by use of an appropriate eutectic alloy in the ion source. A combination of the nanomachined mask and the scanned FIB can be used if the FIB probe size is larger than the apertures in the mask. In this case the probe is scanned to dwell on the apertures in the mask.

We will now describe a method of testing the detector. The method may also be used in a test mode where other ionising radiation, such as X-rays or electrons are applied to cause detectable ionisation. Such a test will confirm that the substrate is electrically active and that the system is working and is sufficiently efficient to detect ion impacts, before ion implantation.

This may be done with a small radioactive source (or other appropriate source of X-rays) that is swung into place in front of the substrate to be implanted. The X-rays deposit the fixed amounts of energy, depending on the source, in the substrate without doing any damage. A pulse height spectrum then provides an indication of the quality of the device. The X-rays penetrate surface layers and can therefore be used even in devices that are completely covered with resist films.

A tuneable energy electron source, or a source of different energy x-rays, could also be used to provide multiple energy particles for energy calibration of the pulse height spectrum.

For all these methods, the ion-induced damage in the substrate must be annealed. After ion implantation a focused laser beam may be used to anneal the ion beam induced damage from the single ion impacts. We have shown this to work well with diamond[8,9] where localised regions (less then 10 microns in diameter) can be annealed without significantly heating the rest of the specimen. An alternative strategy is to use rapid thermal annealing which heats the entire substrate, but this may cause damage to pre-existing structures

In a second aspect the invention is a system according to claim 11 of the attached claims.

**Brief Description of Drawings**

An example of the invention will now be described with reference to the accompanying drawings; in which:

> Fig. 1 is a schematic diagram of an ion detection system.
> Fig. 2 is a graph of an X-ray spectrum from such a system.
> Fig. 3a is a graph of a pulse height spectrum of 14 keV 31 P ion impacts from such a system; and Fig. 3b is a graph of a transient generated from one such impact.
> Fig. 4 is a graph of two 14 keV 31 P ion impacts from such a system.

**Best Modes for Carrying Out the Invention**

This example describes the invention in the context of the construction of a Kane quantum computer which requires $^{31}P$ ions with an energy below 20 keV.

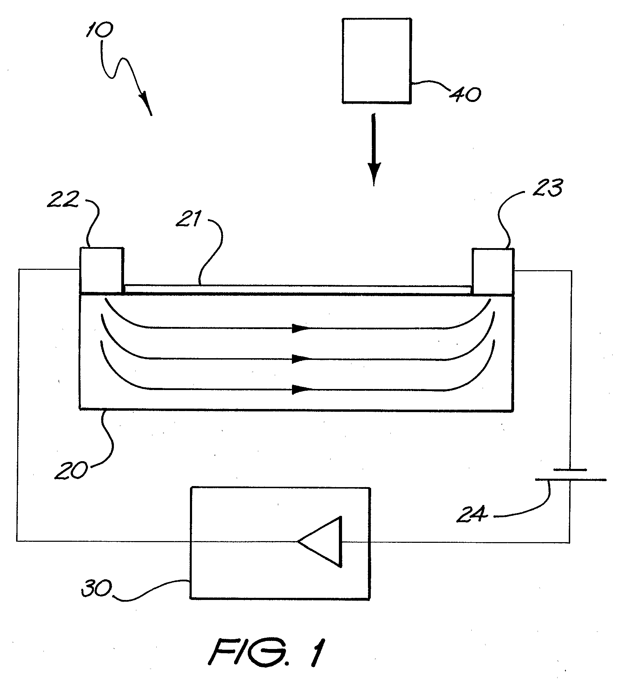

Referring first to Fig. 1 system 10 is used for detecting the impact, penetration and stopping of a single heavy ion, such as $^{31}P$ below 20 keV, in a substrate. The substrate 20 is a 0.2mm thick silicon wafer of greater than 1000 $\Omega \cdot$cm resistivity mounted on a metal contact and earthed. The entire substrate is electrically active silicon and the implantation of a $^{31}P$ ion will generate electron-hole pairs. There is a layer of oxide 5 nm thick 21 and two electrodes 22 and 23 on the surface of the substrate. A potential 24 is applied across the electrodes to create an electric field parallel with the surface to separate and sweep out electron-hole pairs formed within the substrate. A current transient sensor 30 is used to detect transient current in the electrodes and so determine the arrival of a single ion in the substrate.

Since the device 10 has no metal layer or doped layer at the surface, the dead layer 21 thickness can be made much thinner than in devices constructed with a p-n junction or a Schottky structure.

The results of the charge collection efficiency measured in the substrate 20 improved by about 10% to at least 96% when the resistivity of the silicon substrate was increased from 1000 to around 5000-7000 $\Omega \cdot$cm when tested with MeV ion impacts. Hence, substrates made with a high resistivity silicon substrate of high resistivity are most suitable in the fabrication of arrays of single ions using the detection of electrical transients in the substrate from ion impact method. Further improvements in efficiency occur upon cooling the substrate and associated ion detection circuitry to low temperatures, and using Schottky barriers under the electrodes.

When an ion penetrates the substrate it excites electrons out of their energy levels and consequentially leaves holes. These charge carriers are separated by an electric field applied to the electrodes. The negative charge carrier drifts towards the positive electrode and the positive charge carriers drift towards the negative electrode with a velocity which is dependent on the electric field strength. The resulting electrical transient is detected to generate the ion impact signal,

If the high field region does not extend completely through the substrate, a dead region may exist between the electrodes corresponding to an area of low field. Any charge carriers which enter this dead region will have a velocity close to zero and will only drift a minimal distance and will hence recombine. Therefore the electrode configuration must be such that the dead region is as small as possible. The movement of the remaining charge carriers constitutes a small current which can be expressed in terms of a current transient.

The detection of a current transient, indicates that a single atom has been implanted into the substrate at the desired location. The signal from the ion detection system is then used to deflect the ion beam thereby preventing penetration of further ions.

Numerical simulations have been used to optimise the electrode positions to maximise this signal. For $^{31}P$ ions with an energy up to a few 10's of keV, only about 15 % of the residual kinetic energy deposited in the active layer below the oxide produces electron-hole pairs and hence a signal. The remainder, termed the pulse height defect, is lost to nuclear collisions.

Cooling the high purity substrate to the temperature of liquid nitrogen, and appropriate thermal treatment of the detector electrodes to allow large bias voltages to be applied improve system performance.

The current transient sensor 30 includes a detector preamplifier and amplifier system capable of pulse shape discrimination. Pulse shape discrimination may be accomplished by use of a digital storage oscilloscope which digitises the entire transient caused by ion impact, or noise signal. Transient shapes which do not conform to those expected for ion impacts can be rejected.

The discimination can be performed by specalised electronics in the amplifier used to produce the charge transient signal. Spectroscopy amplifiers are available commercially with in-built pulse shape discrimination circuits (such as the ORTEC type 572) that produce a reject signal when pulse pile-up is detected. Pulse pile-up is when two ion signals arrive within a short time period resulting in one pulse with a distorted shape. Although pulse pile-up is not a problem for the strategy outlined here, similar circuits could be used to eliminate large, random noise pulse on the basis of their pulse shape.

The electrical pulse height of any ion beam induced charge in the detector system is used to register a single ion implant event. To prevent multiple implantation of ions at the same location in the substrate, a fast electrostatic deflector unit located upstream of the ion beam target chamber is utilised to deflect the incident ion beam after implantation of one ion is detected.

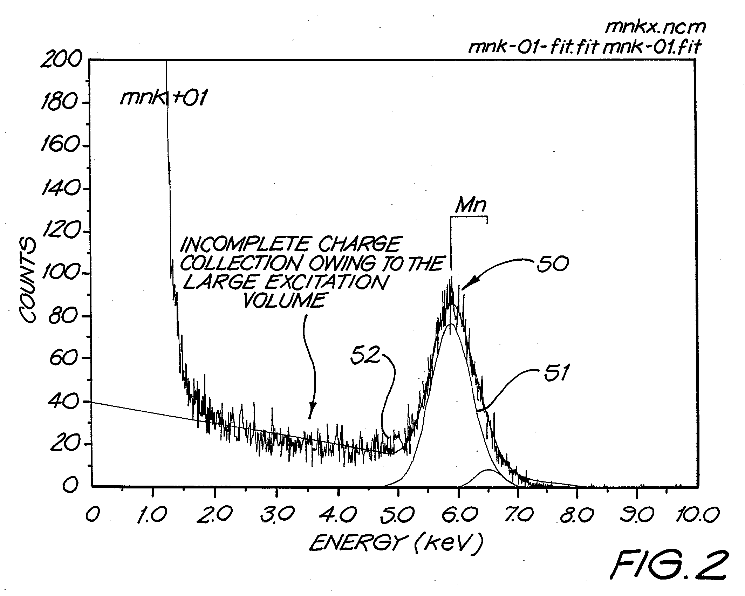

The substrate and system are first tested by irradiating with X-rays from a radioactive source 40, for instance $^{55}$Fe or $^{57}$Co. The X-rays penetrate the substrate and cause ionisation in a reversible manner without causing any damage. Fig. 2 is a graph of the results. The major peak 50 is made up of a signal peak 51 at 5.989 keV, representing $^{55}$Mn $K_\alpha$ x-rays, the decay product from $^{55}$Fe, and a noise signal 52. There is also another minor peak centred at 6.4 keV from Mn $K_\beta$ x-rays. The peak 50 shows the X-rays have been detected.

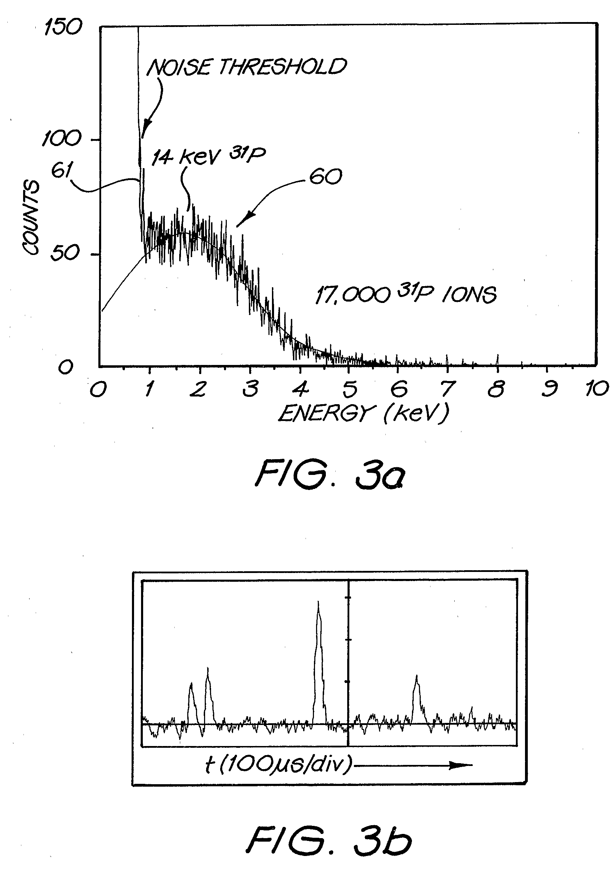

For $^{31}$P ions with an energy up to a few 10's of keV, only about 15 % of the residual kinetic energy deposited in the active layer below the oxide produces electron-hole pairs and hence a signal. Nevertheless, the noisy peak 60 shown in Fig. 3 demonstrates the the system works, and the spectrum shows the detection of 17,000 ion impacts. The noise signal 61 level of 1 keV will be reduced to below 0.5 keV with future improvements to the shielding of the ion detection circuits. The commercially available electronics for this application is rated at 0.2 keV noise level which is suitable for the Kane device.

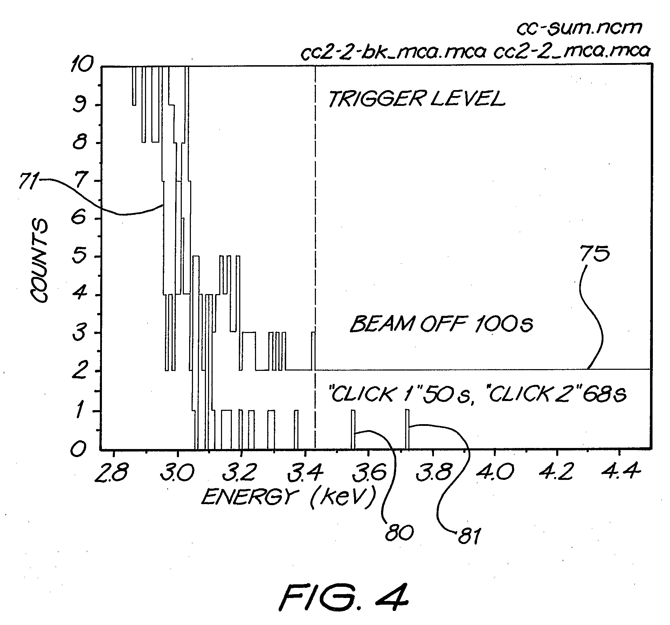

Further work has taken place with a system in which the silicon substrate is covered with a 60 nm resist containing two nanomachined apertures irradiated with 15 keV $^{31}$P ions. This experiment has detected two single $^{31}$P ions being implanted. The evidence for this is shown by the spectra shown in Fig. 4.

In Fig. 4 the noise signal 71 is greater than before, about 3 keV, so the trigger level was set at just above 3.4 keV. The experiment involved testing the noise signals with the beam off to set the trigger level above expected noise counts, and then only irradiating for a short time to decrease the likelihood of counting noise. A first ion ion impact signal 80 was detected after 50 s, and another 81 after 68 s. These results were at 3.55 keV and 3.71 keV respectively and represent deeply implanted atoms that experienced greater electronic stopping and less nuclear stopping than the average. This result will be improved later by reduction of the noise level.

Although the invention has been described with reference to a particular example it should be appreciated that many variations and refinements are possible. So too are many applications for the system and method.

Other devices will have a different configuration; the 5 nm surface oxide described here may not necessarily be present and the beam energy and species may be different.

The straggling caused by nuclear stopping process will introduce lateral and longitudinal tolerances in the $^{31}$P atom locations. Also, calculations by Koiller et al suggest that the exchange coupling between electrons in silicon matrix is a strong function of separation Compensation of these effects will require appropriate potentials to be applied to the gates associated with each qubit. These gates allow the environment of the qubit to be changed allowing individual qubits to be addressed by an NMR pulse or other signals. The fidelity of this operation will depend on the tolerance of the qubit location and the amount of cross talk between qubits from a particular gate field. The gate fields have been calculated by TCAD which also provides the potential for the solutions to the Schrödinger equation allowing the qubit wave functions to be calculated. A fidelity of better than 1 part in $10^4$, required for operation of the device, can be achieved with potentials of less than 1 - 2 V per electrode which is less than the breakdown field of the oxide barrier.

An ion energy of around 15 keV is necessary to ensure the ion range is at the required depth in the substrate which is about 20 nm for the Kane device. A prototype quantum computer element is presently under construction which consists of 2 donors, to be implanted through a mask containing two apertures. When two ion impacts are registered, there is a 50 % probability that each aperture contains 1 donor. Future devices will be fabricated using a focused $^{31}$P beam stepped from cell to cell gated on an ion registration signal which provides the pathway to scaling up to many qubit devices.

We are also developing a moveable nanomachined mask integrated with an AFM cantilever as another pathway to scaling up the device.

The surface of the substrate may be patterned with registration marks to enable the region where the single atom array is to be located. The surface may then be scanned using an AFM in order to locate the registration marks on the surface. The known offset between the cantilever tip and a nano-machined aperture is then used to reposition the cantilever arm with the nano-machined aperture located above the desired location for implantation of the first atom.

The coarse positioning system may be used to move the AFM stage into position beneath the ion beam collimator so that the ion beam can irradiate the back of the cantilever lever and illuminate the nano-machined aperture.

Using an upstream Faraday cup, the beam current from the ion source is adjusted to a beam current of a few tens of pA. The beam is prevented from reaching the cantilever by switching on the deflector unit. Then the beam is directed to a non-essential corner of the substrate to tune the beam current to a few hundred atoms per second using the single ion detection system.

Switching off the deflector unit allows the ion beam to irradiate the cantilever arm.

The substrate is moved to the next location by moving the AFM stage 43. In some cases the AFM 32 can be used to image the location of the ion strike from the changes to the morphology of the surface caused by ion impact and hence verify the success of the ion implant. This will be the case with MeV heavy ions.

To enhance performance charge induced in the substrate must be collected to high efficiency. The device must have a low density of free charge carriers and a low density of defects ie., the charge carriers trapping centres. Cooling of the substrate can be used to reduce free carriers and also noise from the process of thermal ionisation. Without free carriers a low leakage current may be sustained when a high electrical field is applied in the sensitive volume ensuring efficient charge separation. A low density of charge carrier trapping centres and a high charge carrier drifting velocity will reduce the loss to the trapping centres during the charge collection. Additionally, it is desirable that the substrate has a high breakdown electrical field, so that high velocities of the carriers can be obtained in biased devices.

The pulse height in a device is often reduced or shows non-linear response to the ion energy due to three reasons:

> 1. The proportion of the ions energy loss to nuclear stopping without involvement in the ionisation process leading to the e-h pairs production (the Pulse Height Defect - PHD);
> 2. Charge loss at the trapping centres during charge drift or diffusion. This loss increases when the dense plasma produced by heavy ions shields the electrical field; and
> 3. Energy loss at the dead layers. Dead layers must be kept as thin as possible when keV ions are employed.

The references throughout the text above are incorporated herein by reference:

> 1. Kane, B.E., A silicon-based nuclear spin quantum computer, Nature, Vol. 393, p. 133, [1998].
> 2. Vrijen, R., Yablonovitch, E., Wang, K., Jiang, H.W., Balandin, A., Roychowdhury, V., Mor, T., and DiVincenzo, C. Phys. Rev. A62 (2000) 12306.
> 3. PCT Application No PCT/AU01/01056 in the name of Unisearch Limited filed 24/08/01.
> 4. Lüthi, R., Schlittler, R. R., Brugger, J., Vettiger, P., Welland, M. E., Gimzewski, J. K. Parallel nanodevice fabrication using a combination of shadow mask and scanning probe methods. Applied Physics Letters, Vol. 75, Number 9, [1999].
> 5. Shinada, T., Kumura, Y., Okabe, J., Matsukawa, T., Ohdormar, I. Current status of single ion implantation. Journal of Vacuum Science Technologies B, Vol. 16, Number 4, [1998], pp 2489 - 2493.
> 6. Koh, M., Igarashi, K., Sugimoto, T., Mausukawa, T., Mori, S., Arimura. T., Ohodomori, I. Quantitative characterization of Si/Sio2 interface traps induced by energetic ions by means of single ion microprobe and single ion beam induced charge imaging. Applied Surface Science, 117/118, [1997], pp 171-175.
> 7. SRIM - The Stopping and Range of Ions in Solids, by J. F. Ziegler, J. P. Biersack and U. Littmark, Pergamon Press, New York, 1985
> 8. PRAWER, S., JAMIESON, D.N. and KALISH, R. - An investigation of carbon near the diamond/graphite/liquid triple point. Phys. Rev. Letts 69: 2991-2994 (1992).
> 9. ALLEN, M.G., PRAWER, S. AND JAMIESON, D.N. - Pulsed laser annealing of P implanted diamond. Appl. Phys. Lett. 63/15: 2062-2064 (1994).

## Claims

1. A method for single ion doping by detecting the impact, penetration and stopping of a single dopant ion in a semiconductor substrate (20) to create a semiconductor device, the method comprising the steps of:

> impacting a pure semiconductor substrate (20) with single ions to penetrate and stop within the pure semiconductor substrate, and so generate electron-hole pairs within the pure semiconductor substrate;
> applying a potential across two electrodes (22,23) on the surface of the pure semiconductor substrate (20) to create a field to separate and sweep out electron-hole pairs formed within the pure semiconductor substrate; and
> detecting (30) transient current in the electrodes, as a result of the sweeping out of the electron-hole pairs formed by a single ion in order to determine that the single ion has been implanted into the pure semiconductor substrate (20).

2. A method according to claim 1, where the substrate (20) is a high resistivity silicon substrate and the ions are $^{31}$P.

3. A method according to claim 1 or 2, including the step of generating a focused beam of ions from a field ionisation ion source producing sub-20 nm ion beam probes.

4. A method according to claim 3, including the step of gating off the beam after a single ion arrival is detected.

5. A method according to any preceding claim, including a preliminary step of applying (40) ionising radiation to cause detectable ionisation.

6. A method according to claim 5, where the ionising radiation is X-rays or electrons.

7. A method according to any preceding claim, including the steps of applying a thin, ion sensitive resist to the substrate, and later processing the resist to reveal the impact sites of single ions.

8. A method according to any preceding claim, including the steps of dwelling a FIB on a location on the substrate surface where an ion is to be implanted until a single ion impact is detected, and then scanning an FIB over the substrate to a new location, and repeating the dwelling step.

9. A method according to claim 8, where the FIB is a sub-20 nm spot.

10. A method according to claim 8 or claim 9, including the step using a nanomachined mask and dwelling the FIB on the apertures in the mask.

11. A system for single ion doping by detecting the impact, penetration and stopping of a single dopant ion in a semiconductor substrate (20) to create a semiconductor device, comprising:

a pure semiconductor substrate (20) arranged such that single ion impacts generate electron-hole pairs in the pure semiconductor substrate; at least two electrodes (22,23) on the surface of the pure semiconductor substrate to apply a potential (24) across the electrodes to create a field to separate and sweep out electron-hole pairs formed within the pure semiconductor substrate; and a current transient sensor (30) to detect current in the electrodes, as a result of the sweeping out of the electron-hole pairs formed by a single ion in order to determine that the single ion has been implanted into the pure semiconductor substrate.

12. A system according to claim 11, where the substrate (20) is a high resistivity silicon substrate and the ions are $^{31}$P.

13. A system according to claim 11 or claim 12, including a gating subsystem to gate off the beam after a single ion arrival is detected.

14. A system according to any of claims 11 to 13, including source ionising radiation (40) moveable between a first position adjacent the substrate to cause detectable ionisation, and a second position where it does not irradiate the substrate.

15. A system according to claim 14, where the ionising radiation is X-rays or electrons.

16. A quantum computer fabricated using the method of any one of claims 1 to 10.

17. A nanomachined optical fibre fabricated using the method of any one of claims 1 to 10.

18. An integrated chip having controlled dopant implantation fabricated using the method of any one of claims 1 to 10.

19. A resist structure having controlled dopant implantation fabricated using the method of any one of claims 1 to 10.

**Patentansprüche**

1. Ein Verfahren zur Einzelionen-Dotierung zur Feststellung von Aufprall, Penetration und Stoppen eines einzelnen Dotierstoffions in einem Halbleitersubstrat (20) zur Erzeugung eines Halbleiterbauelements, wobei das Verfahren folgende Schritte umfasst:

Aufprallen auf ein reines Halbleitersubstrat (20) mit Einzelionen zur Penetration und Stoppen im reinen Halbleitersubstrat und somit Erzeugen von Elektron-Loch-Paaren im reinen Halbleitersubstrat; Anlegen einer Spannung über zwei Elektroden (22, 23) auf der Oberfläche des reinen Halbleitersubstrats (20) zwecks Erzeugung eines Felds zur Trennung und Ausräumung von Elektronen-Loch-Paaren, die im reinen Halbleitersubstrat gebildet wurden; und Feststellen (30) eines Übergangsstroms in den Elektroden infolge der Ausräumung der Elektron-Loch-Paare, die von einem Einzelion gebildet wurden, um festzustellen, dass das Einzelion in das reine Halbleitersubstrat (20) implantiert wurde.

2. Ein Verfahren entsprechend Anspruch 1, wobei das Substrat (20) ein hochohmiges Siliziumsubstrat ist und die Ionen $^{31}$P sind.

3. Ein Verfahren entsprechend Anspruch 1 oder 2, zu dem der Schritt des Erzeugens eines gezielten Ionenstrahls von einer Feldionisations-Ionenquelle, die Ionenstrahlsonden von unter 20 nm erzeugt.

**4.** Ein Verfahren entsprechend Anspruch 3, einschließlich des Schritts des Ausblendens des Strahls, nachdem das Eintreffen eines Einzelions festgestellt wurde.

**5.** Ein Verfahren entsprechend einem der vorhergehenden Ansprüche, einschließlich eines einleitenden Schritts der Anwendung (40) ionisierender Strahlung zwecks Verursachung feststellbarer Ionisation.

**6.** Ein Verfahren entsprechend Anspruch 5, wobei es sich bei der ionisierenden Strahlung um Röntgenstrahlen oder Elektronen handelt.

**7.** Ein Verfahren entsprechend einem der vorhergehenden Ansprüche, einschließlich des Schritts des Auftragens einer dünnen, ionenempfindlichen Schutzschicht auf das Substrat und späterer Bearbeitung der Schutzschicht, um die Einschlagstellen von Einzelionen aufzuzeigen.

**8.** Ein Verfahren entsprechend einem der vorhergehenden Ansprüche, einschließlich der Schritte des Verweilens eines fokussierten Ionenstrahls (FIB) auf der Substratoberfläche, wo ein Ion implantiert werden soll, bis ein Aufprall eines Einzelions festgestellt wird, gefolgt vom Scannen eines FIBs über dem Substrat zu einer neuen Position und Wiederholen des Verweilschritts.

**9.** Ein Verfahren entsprechend Anspruch 8, wobei der FIB ein Punkt unter 20 nm ist.

**10.** Ein Verfahren entsprechend Anspruch 8 oder Anspruch 9, einschließlich des Schritts der Verwendung einer mit einer Nanomaschine bearbeiteten Maske und Verweilen des FIBs auf den Durchbrüchen der Maske.

**11.** Ein System zur Einzelionen-Dotierung durch Feststellung von Aufprall, Penetration und Stoppen eines einzelnen Dotierstoffions in einem Halbleitersubstrat (20) zur Erzeugung eines Halbleiterbauelements, bestehend aus:

einem reinen Halbleitersubstrat (20) das so angeordnet ist, dass Aufprallen von Einzelionen Elektron-Loch-Paare im reinen Halbleitersubstrat erzeugen;
zumindest zwei Elektroden (22, 23) auf der Oberfläche des reinen Halbleitersubstrats zum Anlegen einer Spannung (24) über die Elektroden zur Erzeugung eines Felds zur Trennung und Ausräumung von Elektronen-Loch-Paaren, die im reinen Halbleitersubstrat gebildet wurden; und
einem Übergangsstromsensor (30) zur Feststellung von Strom in den Elektroden infolge der Ausräumung der Elektron-Loch-Paare, die von einem Einzelion gebildet wurden, um festzustellen, dass das Einzelion in das reine Halbleitersubstrat implantiert wurde.

**12.** Ein System entsprechend Anspruch 11, wobei das Substrat (20) ein hochohmiges Siliziumsubstrat ist und die Ionen $^{31}$P sind.

**13.** Ein System entsprechend Anspruch 11 oder Anspruch 12, einschließlich eines Torschaltuntersystems zum Ausblenden des Strahls, nachdem das Eintreffen eines Einzelions festgestellt wurde.

**14.** Ein System entsprechend einem Ansprüche 11 bis 13, einschließlich einer ionisierenden Strahlungsquelle (40), die zwischen einer ersten Position neben dem Substrat zur Verursachung feststellbarer Ionisation und einer zweiten Position, in der sie das Substrat nicht bestrahlt, versetzt werden kann.

**15.** Ein System entsprechend Anspruch 14, wobei es sich bei der ionisierenden Strahlung um Röntgenstrahlen oder Elektronen handelt.

**16.** Ein Quantencomputer, der unter Verwendung des Verfahrens entsprechend einem der Ansprüche 1 bis 10 hergestellt wird.

**17.** Eine mit einer Nanomaschine bearbeitete optische Faser, die unter Verwendung des Verfahrens entsprechend einem der Ansprüche 1 bis 10 hergestellt wird.

**18.** Ein integrierter Chip mit kontrollierter Dotierstoffimplantation, der unter Verwendung des Verfahrens entsprechend einem der Ansprüche 1 bis 10 hergestellt wird.

**19.** Eine Schutzschichtstruktur mit kontrollierter Dotierstoffimplantation, die unter Verwendung des Verfahrens entsprechend einem der Ansprüche 1 bis 10 hergestellt wird.

**Revendications**

**1.** Procédé de dopage d'ions uniques permettant de détecter l'impact, la pénétration et l'arrêt d'un ion dopant unique dans un substrat semiconducteur (20) de sorte à créer un dispositif semiconducteur, le procédé comprenant les étapes consistant à :

percuter un substrat semiconducteur pur (20) avec des ions uniques pour les faire pénétrer et les arrêter à l'intérieur du substrat semiconducteur et pour produire ainsi des paires électron-trou à l'intérieur du substrat semiconducteur pur ;

appliquer un potentiel à travers deux électrodes (22, 23) sur la surface du substrat seminonducteur pur (20) de sorte à créer un champ permettant de séparer et de balayer des paires électron-trou formées à l'intérieur du substrat semiconducteur pur ; et

détecter (30) un courant transitoire dans les électrodes, suite au balayage des paires électron-trou formées par un ion unique de sorte à déterminer l'implantation d'un ion unique dans le substrat semiconducteur pur (20).

2.  Procédé selon la revendication 1, dans lequel le substrat (20) est un substrat de silicium de résistivité élevée et les ions sont des ions appartenant au noyau $^{31}$P.

3.  Procédé selon la revendication 1 ou la revendication 2, comprenant l'étape consistant à produire un faisceau d'ions focalisés à partir d'une source d'ions d'ionisation de champ produisant des sondes à faisceaux d'ions de structures inférieures à 20 nm.

4.  Procédé selon la revendication 3, comprenant l'étape de coupure du faisceau après la détection de l'arrivée d'un ion unique.

5.  Procédé selon une quelconque revendication précédente, comprenant une étape préliminaire d'application (40) d'un rayonnement ionisant de sorte à causer une ionisation détectable.

6.  Procédé selon la revendication 5, où le rayonnement ionisant est composé de rayons X ou d'électrons.

7.  Procédé selon une quelconque revendication précédente, comportant les étapes d'application d'une fine couche de résist sensible aux ions au substrat, et ensuite de traitement de la couche de résist pour révéler les sites d'impact des ions uniques.

8.  Procédé selon une quelconque revendication précédente, comportant les étapes d'implantation d'un faisceau d'ions focalisé (FIB) à un emplacement sur la surface du substrat où un ion doit être implanté jusqu'à la détection de l'impact d'un ion unique et de balayage d'un FIB par-dessus le substrat à un nouvel emplacement et de répétition de l'étape d'implantation.

9.  Procédé selon la revendication 8, où le FIB est une tache lumineuse de structure inférieure à 20 nm.

10. Procédé selon la revendication 8 ou la revendication 9, comprenant l'étape d'utilisation d'un masque nano-usiné et d'implantation du FIB sur les ouvertures dans le masque.

11. Système de dopage d'ions uniques permettant de détecter l'impact, la pénétration et l'arrêt d'un ion dopant unique dans un substrat semiconducteur (20) de sorte à créer un dispositif semiconducteur, comprenant :

    un substrat semiconducteur pur (20) organisé de manière à ce que des impacts d'ions uniques génèrent des paires électron-trou dans le substrat semiconducteur ;

    au moins deux électrodes (22, 23) sur la surface du substrat semiconducteur pur de sorte à appliquer un potentiel (24) à travers les électrodes pour créer un champ permettant de séparer et de balayer des paires électron-trou formées à l'intérieur du substrat semiconducteur pur ; et

    un détecteur de courant transitoire (30) pour détecter du courant dans les électrodes, suite au balayage des paires électron-trou formées par un ion unique de sorte à déterminer que l'ion unique a été implanté dans le substrat semiconducteur pur.

12. Système selon la revendication 11, où le substrat (20) est un substrat de silicium à résistivité élevée et les ions sont des ions appartenant au noyau $^{31}$P.

13. Système selon la revendication 11 ou la revendication 12, comportant un sous-système de points de contrôle pour couper le faisceau après la détection de l'arrivée d'un ion unique.

14. Système selon l'une quelconque des revendications 11 à 13, comportant un rayonnement ionisant source (40) mobile entre une première position adjacente au substrat pour causer une ionisation détectable et une seconde position où il n'irradie pas le substrat.

15. Système selon la revendication 14, où le rayonnement ionisant est composé de rayons X ou d'électrons.

16. Ordinateur quantique fabriqué en utilisant le procédé de l'une quelconque des revendications 1 à 10.

17. Fibre optique nano-usinée fabriquée en utilisant le procédé de l'une quelconque des revendications 1 à 10.

18. Puce intégrée ayant une implantation de dopant contrôlée fabriquée en utilisant le procédé de l'une quelconque des revendications 1 à 10.

19. Structure de résist ayant une implantation de dopant contrôlée fabriquée en utilisant le procédé de l'une quelconque des revendications 1 à 10.

FIG. 1

FIG.2

FIG. 3a

FIG. 3b

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5539203 A
- US 4675601 A
- AU 0101056 W

### Non-patent literature cited in the description

- An automated single ion hit at JAERI heavy ion microbeam to observe individual radiation damage. **KAMIYA T et al.** Nuclear Instruments & Methods in Physics Research, Section - B:Beam Interactions with Materials and Atoms. Elsevier, 02 September 1999, vol. 158, 255-259
- Spatially resolved imaging of charge collection efficiency in polycrystalline CVD diamond by the use of ion beam current. **BECKMANN D R et al.** Nuclear Instruments & Methods in Physics Research, Section - B:Beam Interactions with Materials and Atoms. Elsevier, 01 July 1997, vol. 130, 518-523
- **KANE, B.E.** A silicon-based nuclear spin quantum computer. *Nature,* 1998, vol. 393, 133
- **VRIJEN, R. ; YABLONOVITCH, E. ; WANG, K. ; JIANG, H.W. ; BALANDIN, A. ; ROYCHOWDHURY, V. ; MOR, T. ; DIVINCENZO, C.** *Phys. Rev.,* 2000, vol. A62, 12306
- **LÜTHI, R. ; SCHLITTLER, R. R. ; BRUGGER, J. ; VETTIGER, P. ; WELLAND, M. E. ; GIMZEWSKI, J. K.** Parallel nanodevice fabrication using a combination of shadow mask and scanning probe methods. *Applied Physics Letters,* 1999, vol. 75 (9
- **SHINADA, T. ; KUMURA, Y. ; OKABE, J. ; MATSUKAWA, T. ; OHDORMAR, I.** Current status of single ion implantation. *Journal of Vacuum Science Technologies B,* 1998, vol. 16 (4), 2489-2493
- **KOH, M. ; IGARASHI, K. ; SUGIMOTO, T. ; MAUSUKAWA, T. ; MORI, S. ; ARIMURA. T. ; OHODOMORI, I.** Quantitative characterization of Si/Sio2 interface traps induced by energetic ions by means of single ion microprobe and single ion beam induced charge imaging. *Applied Surface Science,* 1997, vol. 117/118, 171-175
- SRIM. **J. F. ZIEGLER ; J. P. BIERSACK ; U. LITTMARK.** The Stopping and Range of Ions in Solids. Pergamon Press, 1985
- **PRAWER, S. ; JAMIESON, D.N. ; KALISH, R.** An investigation of carbon near the diamond/graphite/liquid triple point. *Phys. Rev. Letts,* 1992, vol. 69, 2991-2994
- **ALLEN, M.G. ; PRAWER, S. ; JAMIESON, D.N.** Pulsed laser annealing of P implanted diamond. *Appl. Phys. Lett.,* 1994, vol. 63/15, 2062-2064